# EUROPEAN PATENT APPLICATION

(11) **EP 4 851 640 A1**
(43) Date of publication of application: **09.12.2026**
(21) Application number: 25761999.9
(22) Date of filing: 27.02.2025
(51) Int. Cl.: G01R 29/22, H10N 30/01

(54) **PIEZOELECTRIC CONSTANT MEASURING DEVICE**

(30) Priority: 29.02.2024 JP 2024029338
(71) Applicant: University Public Corporation Osaka, Osaka-shi, Osaka 5360025 (JP); Lead Techno Co., Ltd., Nara-shi, Nara 631-0011 (JP)
(72) Inventor: YOSHIMURA Takeshi, Sakai-shi Osaka 599-8231 (JP); HAYANO Shuji, Nara-shi Nara 631-0011 (JP); TABATA Toshinari, Nara-shi Nara 631-0011 (JP)
(74) Representative: Yoshida, Senko
(86) International application number: PCT/JP2025/006939
(87) International publication number: WO 2025/183105

(57) **Abstract**

There is provided a piezoelectric constant measuring device capable of measuring a piezoelectric constant d33 with high accuracy even by applying a smaller load to a piezoelectric thin film on a wafer. The piezoelectric constant measuring device 1 is for measuring the piezoelectric constant d33 of a piezoelectric thin film W3 formed on a wafer WA and includes a wafer table 2, a first electrode 3 which can come in contact with a predetermined portion of the wafer WA, a second electrode 4, a second-electrode load means 5 which is controlled by a reference frequency signal and can apply a periodic load to the piezoelectric thin film W3 through the second electrode 4, a load measuring means 6 adapted to output an amplitude value of the periodic load or a value proportional thereto, a reference frequency signal generator 7 adapted to output the reference frequency signal, a lock-in amplifier 8 to which an electric current caused by an electric charge generated in the piezoelectric thin film W3 is inputted as a to-be-measured signal, through the second electrode 4, and to which the reference frequency signal is inputted as a reference signal, and moreover which outputs an amplitude value of the to-be-measured signal or a value proportional thereto, and a piezoelectric-constant measurement control means 9 adapted to calculate the piezoelectric constant d33.

## Description

### Technical Field

The present invention relates to a piezoelectric constant measuring device for measuring a piezoelectric constant d33 of a piezoelectric thin film formed on a lower electrode layer on a substrate in a wafer.

### Background Art

Piezoelectric devices have been employed in wide fields of various sensors, actuators and the like. Such piezoelectric devices can be quantitively evaluated relative to piezoelectric characteristics, through measurement of piezoelectric constants thereof. Such piezoelectric constants include d31, d33 and the like, each corresponding to the direction of an applied load, and the amount of electric charge generated by the applied load. Measurement of piezoelectric constants can be implemented by various types of piezoelectric constant measuring devices. For example, PATENT DOCUMENT 1 discloses a piezoelectric constant measuring device that is enabled to measure d31 by being attached with a jig even though this device is dedicated for the piezoelectric constant d33. PATENT DOCUMENT 2 discloses a piezoelectric constant measuring device, which is capable of measuring the amount of change in a plurality of pulse-shaped amounts of electric charges generated by a plurality of pulsed loads, and calculating the piezoelectric constants d33 (and d31) from the amount of change and the measured pulsed loads.

In recent years, due to the trends of reduction in both sizes and power consumptions of piezoelectric devices, developments and commodification of piezoelectric devices using piezoelectric thin films (thin films made of piezoelectric materials), such as PVDF films and PZT films, have become more active. Such a piezoelectric thin film is formed through sputtering or the like, on a lower electrode layer on a substrate in a wafer made of silicon or the like. Thereafter, the wafer is subjected to subsequent processing such as formation of an upper electrode layer thereon and, then, the wafer is divided into predetermined shapes, thereby being formed as piezoelectric device products.

In general, in an extraction inspection for determining as to whether the piezoelectric thin film is appropriate, a wafer is extracted from the manufacturing line, and, only a portion of the wafer having a predetermined shape is cut off therefrom, and then a piezoelectric constant thereof is measured by a piezoelectric constant measuring device. Such an extraction inspection is a destructive inspection, which causes the extracted wafer to be unusable thereafter. For coping therewith, for example, there has been suggested a nondestructive inspection for measuring the piezoelectric constant d33 in the state of a wafer, as described in PATENT DOCUMENT 3.

### Prior Art Documents

### Patent Documents

PATENT DOCUMENT 1: Japanese Patent Application Publication No. 2014-081339
PATENT DOCUMENT 2: Japanese Patent No. 6241975
PATENT DOCUMENT 3: Japanese Patent Application Publication No. 2022-128529

### Summary of Invention

### Technical Problem

However, if an attempt is made to measure the piezoelectric constant d33 in a state where an upper electrode layer has not been formed, there are problems specific to a piezoelectric thin film on a wafer in that there is no choice but to make the load applied to the piezoelectric thin film smaller, and in that the piezoelectric thin film is in an unpolarized state.

The present invention has been made in view of the aforementioned circumstances, and an object of the present invention is to provide a piezoelectric constant measuring device capable of measuring the piezoelectric constant d33 with high accuracy, even by applying a smaller load to a piezoelectric thin film on a wafer, in measuring the piezoelectric constant d33 in a state where no upper electrode layer has been formed thereon. A further object of the present invention is to provide a piezoelectric constant measuring device capable of measuring the piezoelectric constant d33 with high accuracy, even when the piezoelectric thin film is in an unpolarized state.

### Solution to Problem

In order to attain the aforementioned objects, a piezoelectric constant measuring device according to the present invention is a piezoelectric constant measuring device for measuring a piezoelectric constant d33 of a piezoelectric thin film formed on a lower electrode layer on a substrate in a wafer, the piezoelectric constant measuring device including: a wafer table adapted to support the substrate; a first electrode which is grounded and can come in contact with a predetermined portion of the wafer; a second electrode; a second-electrode load means which is controlled by a reference frequency signal and can apply a periodic load with a frequency equal to a frequency of the reference frequency signal to the piezoelectric thin film through the second electrode; a load measuring means adapted to convert the periodic load into an alternating signal and output an amplitude value of the periodic load or a value proportional thereto; a reference frequency signal generator adapted to generate and output the reference frequency signal; a lock-in amplifier to which an electric current caused by an electric charge generated in the piezoelectric thin film due to the periodic load applied thereto is inputted, as a to-be-measured signal, through the second electrode, and to which the reference frequency signal or the alternating signal is inputted as a reference signal, and which outputs an amplitude value of the to-be-measured signal or a value proportional thereto; and a piezoelectric-constant measurement control means adapted to calculate the piezoelectric constant d33 from the amplitude value of the to-be-measured signal or the value proportional thereto and from the amplitude value of the periodic load or the value proportional thereto.

The aforementioned piezoelectric constant measuring device can further include a pulse generator capable of generating a pulse with predetermined polarity, height and width, and a relay adapted to change over between passage of the electric current caused by the electric charge generated in the piezoelectric thin film, and passage of the pulse, wherein the pulse can be applied to the piezoelectric thin film through the second electrode, after passing through the relay.

The second electrode can include a base portion formed from a synthetic resin, and a metal adhered to a surface of at least a lower portion of the base portion.

### Effect of Invention

With the piezoelectric constant measuring device according to the present invention, in measuring the piezoelectric constant d33 in a state where no upper electrode layer has been formed, it is possible to measure the piezoelectric constant d33 with high accuracy, even by applying a smaller load to a piezoelectric thin film on a wafer. Further, by providing the pulse generator and the relay therein, it is possible to measure the piezoelectric constant d33 with high accuracy, even when the piezoelectric thin film is in an unpolarized state.

### Brief Description of Drawings

[Fig. 1] illustrates a piezoelectric constant measuring device according to an embodiment of the present invention, illustrating a wafer table, a first electrode, a second electrode, a second-electrode load means, and a portion of a load measuring means by a cross-sectional view, and illustrating another portion of the load measuring means, a reference frequency signal generator, a lock-in amplifier, and a piezoelectric-constant measurement control means by a block diagram (or a schematic diagram).
[Fig. 2] is a plan view illustrating an example of placement of the first electrode in the same piezoelectric constant measuring device.
[Fig. 3] is a view illustrating an example of different placement of the first electrode in the piezoelectric constant measuring device illustrated in Fig. 1.
[Fig. 4] is an enlarged cross-sectional view illustrating the second electrode in the same piezoelectric constant measuring device, where (a) illustrates one having a base portion all made of the same material, and (b) illustrates one having a base portion constituted by a lower ball-shaped portion and a holder portion, which are made of different materials.
[Fig. 5] is a waveform diagram illustrating an example of a load applied to a piezoelectric thin film in the same piezoelectric constant measuring device.
[Fig. 6] is a schematic diagram illustrating an example of the structure of the lock-in amplifier in the same piezoelectric constant measuring device.
[Fig. 7] is a schematic diagram illustrating an example of the structure of the piezoelectric-constant measurement control means in the same piezoelectric constant measuring device.
[Fig. 8] is a view illustrating the result of experiments of measurements of a piezoelectric constant d33, which were implemented by varying a reference frequency, using the wafer table, the first electrode, the second electrode, the second-electrode load means, and the load measuring means, the reference frequency signal generator, and the lock-in amplifier in the same piezoelectric constant measuring device illustrated in Fig. 1.
[Fig. 9] is a view illustrating a structure having a pulse generator and a relay in addition to the piezoelectric constant measuring device illustrated in Fig. 1.
[Fig. 10] is a view illustrating the result of experiments of measurements of the piezoelectric constant d33, which were implemented after application of respective pulses with different pulse voltages, using the piezoelectric constant measuring device illustrated in Fig. 9.

### Description of Embodiments

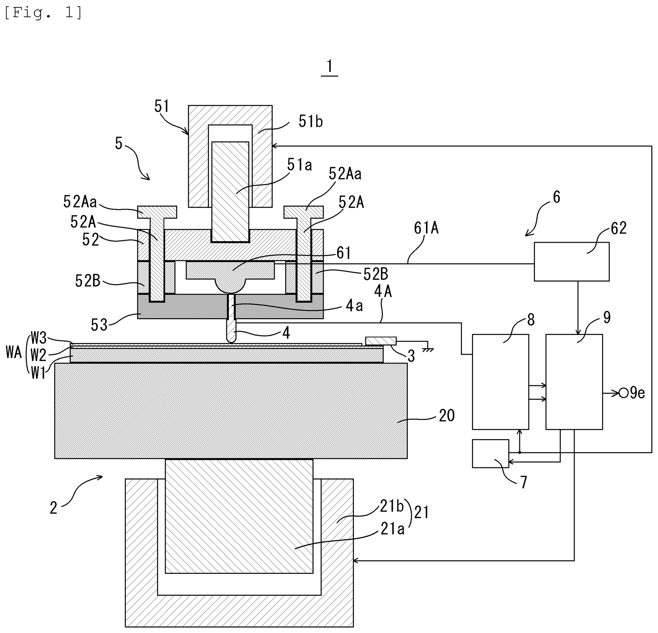

Hereinafter, an embodiment for carrying out the present invention will be described. A piezoelectric constant measuring device 1 according to the embodiment of the present invention is for measuring the piezoelectric constant d33 of a piezoelectric thin film W3 (with a thickness of 1 µm to 200 µm, for example) formed on a lower electrode layer W2 on a substrate W1 in a wafer WA (see Fig. 1). The piezoelectric thin film W3 is formed on the lower electrode layer W2 through sputtering or the like, after the lower electrode layer W2 made of a noble metal, a metal or the like has been formed on the substrate W1 made of silicon, a metal (for example, a SUS or a Ni alloy), or the like in the wafer WA, in a manufacturing line. After the measurement of the piezoelectric constant d33 by the piezoelectric constant measuring device 1, the wafer WA can be subjected to subsequent processing such as formation of an upper electrode layer thereon and, thereafter, the wafer WA can be divided into predetermined shapes, thereby forming piezoelectric device products.

The piezoelectric constant d33 can be calculated (measured) from the amount of electric charge generated in the piezoelectric thin film W3 when a load is applied to the piezoelectric thin film W3 in the thickwise direction, and from the load applied thereto. Here, when a load is applied to the piezoelectric thin film W3 by bringing a second electrode 4 into contact with a portion of the piezoelectric thin film W3 as will be described later, in a state where the upper electrode layer has not been formed, there is no choice but to make the applied load smaller, in order to prevent physical deformation and changes of piezoelectric characteristics at the contact portion and a portion therearound. This reduces the amount of electric charge generated in the piezoelectric thin film W3, which makes noise components relatively larger, thereby resulting in a significantly smaller S/N ratio in a signal (specifically, an electric current) caused by the electric charge. Incidentally, noises are generated by the piezoelectric constant measuring device 1 itself or transferred from other devices and the like. Such noises remain even when various countermeasures are made, by attaching vibration removing members, shield members and the like to respective members, and by forming respective lead wires to be coaxial cables, for example.

The piezoelectric constant measuring device 1, which measures the piezoelectric constant d33 of the piezoelectric thin film W3 in the state of the wafer WA, includes a wafer table 2, a first electrode 3, the second electrode 4, a second-electrode load means 5, a load measuring means 6, a reference frequency signal generator 7, a lock-in amplifier 8, and a piezoelectric-constant measurement control means 9, as illustrated in Fig. 1. Further, in Fig. 1, the respective portions of the wafer WA and the like are illustrated in a manner that they are enlarged in the thickwise direction, for convenience of illustration.

The wafer table 2 is for placing the wafer WA thereon and for supporting it. The wafer table 2 can be made movable in a two-dimensionally horizontal direction, in order to enable measurement of the piezoelectric constant d33 of the piezoelectric thin film W3 at a plurality of positions in the wafer WA.

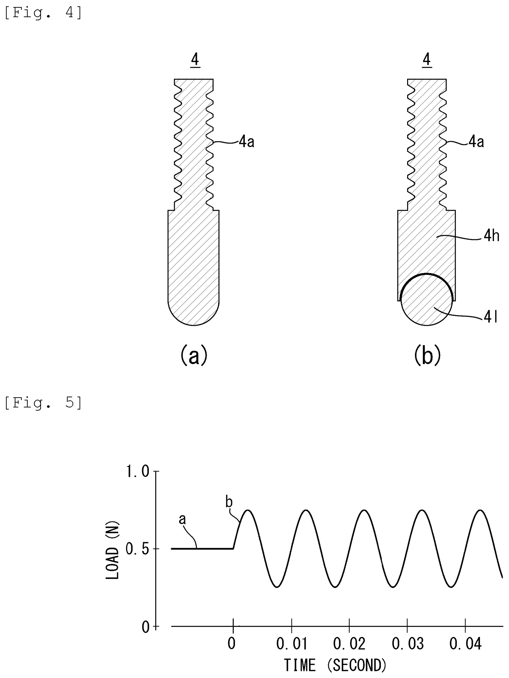

Further, the wafer table 2 (specifically, a wafer-table main body 20 which will be described later) can be made movable upwardly and downwardly, such that it can ascend when a static load (initial load) of a certain value (see the reference sign "a" in Fig. 5 which will be described later) is applied to the piezoelectric thin film W3. If the wafer table 2 is ascended, the second electrode 4 is brought into contact with the piezoelectric thin film W3. At this time, the second electrode 4 is kept staying. This enables measurement of the load by a load detector 61, which will be described later, in the load measuring means 6. If the wafer table 2 is further ascended, a static load is applied to the piezoelectric thin film W3. This enables applying a periodic load (alternate force) (see the reference sign "b" in Fig. 5) to the piezoelectric thin film W3, through the second electrode 4. Also, rather than ascending the wafer table 2, it is possible to descend the second electrode 4 for bringing it into contact with the piezoelectric thin film W3, and it is possible to further descend the second electrode 4 to apply a static load thereto.

Specifically, the wafer table 2 can be structured to include the wafer-table main body 20, and a first linear motor 21 for moving the wafer-table main body 20 upwardly and downwardly. The first linear motor 21 is a motor adapted to linearly move a linear movement portion 21a, using a supporting portion 21b as a reference position. The linear movement portion 21a is secured at its upper end portion to the wafer-table main body 20, and the supporting portion 21b is secured to a frame (not illustrated) in the piezoelectric constant measuring device 1. The first linear motor 21 can be constituted by a servo motor or the like, although not particularly limited thereto. The first linear motor 21 can be controlled by the piezoelectric-constant measurement control means 9.

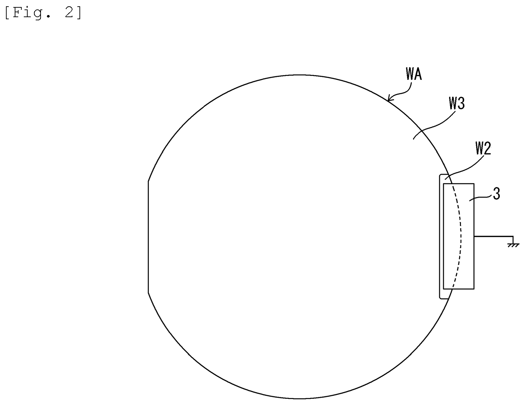

The first electrode 3 can come in contact with a predetermined portion of the wafer WA, in order to keep the lower electrode layer W2 at an earth electric potential, and the first electrode 3 is grounded to be at the earth electric potential. Specifically, the first electrode 3 can be brought into contact with the vicinity of the peripheral edge of the lower electrode layer W2, manually or by being controlled by the piezoelectric-constant measurement control means 9, when the piezoelectric constant d33 of the piezoelectric thin film W3 is measured. Here, the vicinity of the peripheral edge of the lower electrode layer W2, with which the first electrode 3 is brought into contact, can be a portion where the piezoelectric thin film W3 has been partially removed chemically or mechanically, in the vicinity of the peripheral edge of the wafer WA, as illustrated in Fig. 2. In this case, the portion where the piezoelectric thin film W3 has been removed is preferably a portion not to be used as a piezoelectric device product. Incidentally, by bringing the first electrode 3 into contact with the vicinity of the peripheral edge of the lower electrode layer W2, as described above, it is possible to easily keep the lower electrode layer W2 at the earth electric potential through the first electrode 3, even when there is an insulation layer between the substrate W1 and the lower electrode layer W2 in the wafer WA.

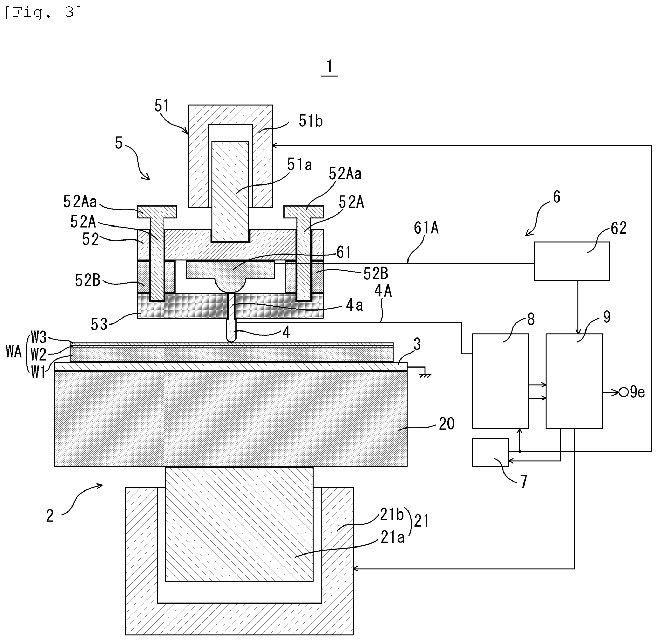

When there is not provided an insulation layer between the substrate W1 and the lower electrode layer W2 in the wafer WA, or when there is provided such an insulation layer but the wafer WA is large to provide a capacity with a sufficiently large capacity value between the substrate W1 and the lower electrode layer W2, the first electrode 3 can be brought into contact with the back surface (the lower surface in Fig. 3) of the substrate W1, as illustrated in Fig. 3, instead of being brought into contact with the vicinity of the peripheral edge of the lower electrode layer W2. This is because there is maintained conductivity from the lower electrode layer W2 to the first electrode 3 in the wafer WA, when there is not provided an insulation layer between the substrate W1 and the lower electrode layer W2 in the wafer WA. Further, when there is provided an insulation layer between the substrate W1 and the lower electrode layer W2 but the wafer WA is large to provide a capacity with a sufficiently large capacity value between the substrate W1 and the lower electrode layer W2, the electric potential at the lower electrode layer W2 can be substantially stabilized, at the frequency and the amplitude value of the periodic load, which will be described later. In the case of bringing the first electrode 3 into contact with the back surface of the substrate W1 as described above, it is possible to provide the first electrode 3 immediately on the wafer table 2 over substantially the same area as that of the wafer table 2.

The second electrode 4 is brought into contact with the piezoelectric thin film W3 from thereabove, when the piezoelectric constant d33 of the piezoelectric thin film W3 is measured. An electric lead wire 4A is connected to the second electrode 4 (or another portion at the same electric potential as that of the second electrode 4). The second electrode 4 is not particularly limited in shape, but can be made to have a substantially semi-spherical shape at its lower end surface, as illustrated in Figs. 4(a) and 4(b), for example. The second electrode 4 can be formed from a brass, a stainless steel or the like, so as to stably and easily come in contact with the piezoelectric thin film W3. Also, the second electrode 4 can include a base portion made of a synthetic resin (for example, a nylon), and a metal (for example, gold or silver) adhered to the surface of at least a lower portion of the base portion. Fig. 4(a) illustrates a second electrode 4 having a base portion all made of the same material (for example, a brass or a stainless steel). Fig. 4(b) illustrates a second electrode 4 having two base portions made of different materials, and including a ball-shaped base portion (lower ball-shaped portion) 4l made of a synthetic resin and a metal adhered to the surface of its entirety, not to the surface of only its lower portion, and a base portion (holder portion) 4h made of a brass or a stainless steel, for example, and adapted to contact with the base portion 4l for holding the same. The base portion 4l made of a synthetic resin and a metal adhered to the surface thereof as described above has elasticity, as compared with a base portion made of a brass, a stainless steel or the like. Therefore, the base portion 4l can highly intimately contact with the piezoelectric thin film W3, and can easily and more stably contact with the piezoelectric thin film W3.

The second-electrode load means 5 applies a periodic load (alternate force) with a certain period to the piezoelectric thin film W3, through the second electrode 4. The second-electrode load means 5 is controlled by a reference frequency signal outputted from the reference frequency signal generator 7. The periodic load is changed by the frequency of the reference frequency signal and is applied while a static load (initial load) (see the reference sign "a" in Fig. 5) is applied (for about 2 seconds to about 20 seconds, for example), as illustrated by a reference sign "b" in Fig. 5. For example, the value of the static load can be about 0.5 N, and the amplitude value of the periodic load can be about 0.25 N. Further, in Fig. 5, there is illustrated the periodic load, when the frequency of the reference frequency signal is 100 Hz.

By applying the periodic load with the certain period, as described above, an electric charge is generated in the piezoelectric thin film W3, such that the electric charge changes at a certain period in synchronization with the periodic load.

Specifically, the second-electrode load means 5 can be structured to include a second linear motor 51, a load-detector attachment plate 52, and a second-electrode attachment plate 53. The second linear motor 51 can linearly move (straightly move) the second electrode 4, through the load-detector attachment plate 52, and a load detector 61, which will be described in detail after, of the load measuring means 6. The second linear motor 51 is controlled by the reference frequency signal outputted from the reference frequency signal generator 7.

The second linear motor 51 is a motor adapted to linearly move a linear movement portion 51a, using a supporting portion 51b as a reference position. The linear movement portion 51a is secured at its lower end portion to the load-detector attachment plate 52, and the supporting portion 51b is secured to the frame (not illustrated) in the piezoelectric constant measuring device 1. The second linear motor 51 can be constituted by a VCM, a servo motor, or the like, although not particularly limited thereto.

The load-detector attachment plate 52 is for attaching the load detector 61 thereto, such that the load detector 61 can detect forces from therebelow.

The second-electrode attachment plate 53 is for attaching the second electrode 4 thereto, such that the end portion (the end portion that can come in contact with the piezoelectric thin film W3) of the second electrode 4 is directed downwardly. Specifically, the second electrode 4 is provided, at its upper portion, with a securing portion 4a, which is secured to the second-electrode attachment plate 53 through screwing or the like. The securing portion 4a is exposed, at its upper end surface, from the second-electrode attachment plate 53. Load-detector attachment-plate sliding rods 52A, 52A are mounted in the upper surface of a peripheral portion of the second-electrode attachment plate 53 and, further, the aforementioned load-detector attachment plate 52 is positioned above the second-electrode attachment plate 53, with load-detector holding springs 52B, 52B interposed therebetween. The load-detector attachment plate 52 and the second-electrode attachment plate 53 are made movable upwardly and downwardly relative to each other, by being guided by the load-detector attachment-plate sliding rods 52A, 52A and by being buffered by the load-detector holding springs 52B, 52B. Further, the load-detector attachment-plate sliding rods 52A, 52A are provided, at their upper portions, with head portions 52Aa, 52Aa, which determine the largest interval between the load-detector attachment plate 52 and the second-electrode attachment plate 53, respectively.

The load measuring means 6 measures the load (the static load and the periodic load) being applied to the piezoelectric thin film W3. According to the present embodiment, the load measuring means 6 includes the load detector (load cell) 61 for detecting the load, and a load-measurement processor 62 for converting an electric signal (for example, an electric current) corresponding to the detected load into data and outputting the data. When measuring the periodic load, the load measuring means 6 can convert the periodic load into an alternating signal (for example, an alternating electric current) by the load detector 61 and can output the alternating signal to the load-measurement processor 62, and further can output data of the amplitude value of the periodic load (or data of a value proportional to the amplitude value of the periodic load) from the load-measurement processor 62. Further, such a value proportional to the amplitude value of the periodic load is the root-mean-square value (RMS) of the periodic load, for example. There is a relationship of N_{RMS} = N₀/(√2), where N₀ indicates the amplitude value of the periodic load, and N_{RMS} indicates the root-mean-square value of the periodic load.

The load detector 61 in the load measuring means 6 is incorporated in the mechanism of the second-electrode load means 5 and, in Fig. 1, a reference sign "61A" denotes an electric lead wire for connecting the load detector 61 and the load-measurement processor 62 to each other. The load-measurement processor 62 can be also integrated with the load detector 61.

The reference frequency signal generator 7 can generate and output a reference frequency signal with a reference frequency f (for example, 1 Hz to 500 Hz). The reference frequency signal is a sine wave, in general. The reference frequency signal generator 7 can be controlled, in terms of on/off of the output thereof, by the piezoelectric-constant measurement control means 9.

An electric current caused by the electric charge generated in the piezoelectric thin film W3, as a to-be-measured signal, is inputted to the lock-in amplifier 8 through the second electrode 4, and, further, the aforementioned reference frequency signal as a reference signal is inputted to the lock-in amplifier 8. The lock-in amplifier 8 outputs data of the amplitude value of the to-be-measured signal (namely, the amplitude value of the electric current caused by the electric charge generated in the piezoelectric thin film W3) (or data of a value proportional to the amplitude value of the to-be-measured signal). Incidentally, such a value proportional to the amplitude value of the to-be-measured signal is the root-mean-square value (RMS) of the to-be-measured signal, for example. There is a relationship of I_{RMS} = I₀/(√2), where I₀ indicates the amplitude value of the to-be-measured signal, and I_{RMS} indicates the root-mean-square value of the to-be-measured signal.

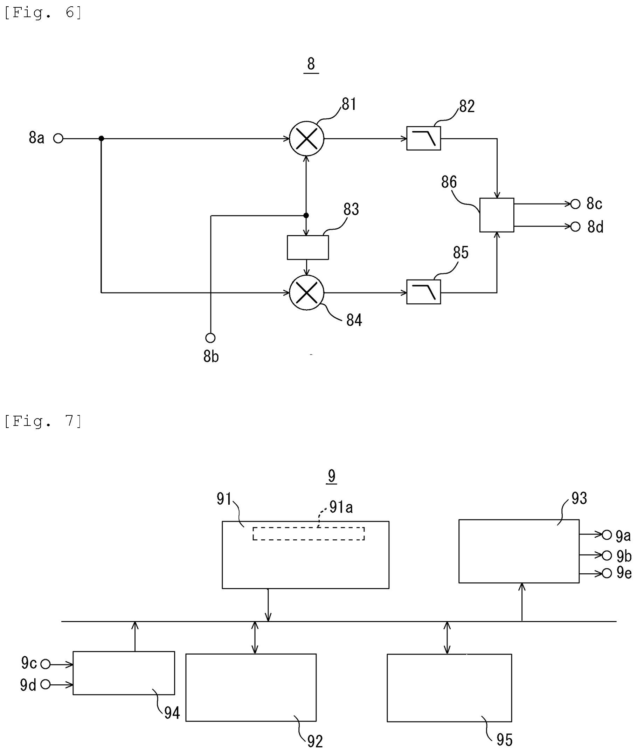

The lock-in amplifier 8 is priorly known and may have various types of circuit structures, but, as illustrated in Fig. 6, includes, as a basic structure, a first mixer 81, a first low-pass filter 82, a phase shifter 83, a second mixer 84, a second low-pass filter 85, and a polar coordinate transformation unit 86, and further includes two input terminals (a first input terminal 8a and a second input terminal 8b), and two output terminals (a first output terminal 8c and a second output terminal 8d). The electric lead wire 4A is connected to the first input terminal 8a, and the electric current caused by the electric charge generated in the piezoelectric thin film W3, as the to-be-measured signal, is inputted to the first input terminal 8a. Further, the reference frequency signal outputted from the reference frequency signal generator 7, as the reference signal, is inputted to the second input terminal 8b. From the first output terminal 8c, the amplitude value of the to-be-measured signal (namely, data of the amplitude value of the electric current caused by the electric charge generated in the piezoelectric thin film W3 (or data of a value proportional to the amplitude value of the to-be-measured signal)) is outputted. From the second output terminal 8d, data of the phase difference between the to-be-measured signal (namely, the electric current caused by the electric charge generated in the piezoelectric thin film W3) and the reference signal (namely, the reference frequency signal) is outputted.

A general outline of the operations of the lock-in amplifier 8 is as follows. The electric charge generated in the piezoelectric thin film W3 is synchronized with the reference frequency f of the reference frequency signal, since the second-electrode load means 5 is controlled by the reference frequency signal. The electric current caused by the electric charge generated in the piezoelectric thin film W3, and the reference frequency signal are inputted to the first mixer 81 to be subjected to mixing (multiplication) therein, whereby a high frequency wave with a frequency of 2f, and a DC (0 Hz) are output basically. These are passed through the first low-pass filter 82, which outputs only the DC. Further, the reference frequency signal is shifted in phase by 90° by the phase shifter 83. The electric current caused by the electric charge generated in the piezoelectric thin film W3, and the reference frequency signal having been shifted in phase by 90° are inputted to the second mixer 84 to be subjected to mixing (multiplication) therein, whereby a high frequency wave with a frequency of 2f, and a DC (0 Hz) are output basically. These are passed through the second low-pass filter 85, which outputs only the DC. The output from the first low-pass filter 82, and the output from the second low-pass filter 85 are subjected to transformation by the polar coordinate transformation unit 86, which results in an output indicating the amplitude value (or a value proportional to the amplitude value) of the electric current caused by the electric charge generated in the piezoelectric thin film W3, and an output indicating the phase difference between the electric current caused by the electric charge generated in the piezoelectric thin film W3, and the reference frequency signal. Incidentally, in general, when the piezoelectric thin film W3 is not in an unpolarized state, the phase difference is about +90° or about -90° depending on the positive and negative polarities.

Here, noise components added to the electric charge generated in the piezoelectric thin film W3 can be eliminated by the first low-pass filter 82 and the second low-pass filter 85. Therefore, even when the amount of electric charge generated in the piezoelectric thin film W3 is smaller, thereby resulting in a significantly smaller S/N ratio of the electric current caused by the electric charge, the data of the amplitude value (or the data of the value proportional to the amplitude value) of the electric current caused by the electric charge generated in the piezoelectric thin film W3, and the data of the phase difference, which are outputted from the lock-in amplifier 8, reflect the amount of the electric charge generated in the piezoelectric thin film W3 with higher accuracy. Incidentally, the lock-in amplifier 8 can be integrated with the reference frequency signal generator 7. Further, instead of the aforementioned reference frequency signal outputted from the reference frequency signal generator 7, the alternating signal outputted from the load detector 61 can be inputted, as a reference signal, to the lock-in amplifier 8. This is because the alternating signal outputted from the load detector 61 is synchronized with the aforementioned reference frequency signal.

The piezoelectric-constant measurement control means 9 is capable of ascending the wafer table 2 by controlling the upward and downward movements of the wafer table 2, as described above, when a static load is applied to the piezoelectric thin film W3. Further, the piezoelectric-constant measurement control means 9 is capable of turning on the output of the reference frequency signal generator 7, by controlling on/off of the output of the reference frequency signal generator 7, when a periodic load is applied to the piezoelectric thin film W3, as described above.

Further, the piezoelectric-constant measurement control means 9 calculates the piezoelectric constant d33, from the data (or the data of the value proportional to the amplitude value of the to-be-measured signal) of the amplitude value of the to-be-measured signal (namely, the amplitude value of the electric current caused by the electric charge generated in the piezoelectric thin film W3), which has been outputted from the lock-in amplifier 8, and from the data of the amplitude value of the periodic load (or the data of the value proportional to the amplitude value of the periodic load), which has been measured by the load measuring means 6.

Specifically, the piezoelectric constant d33 can be calculated by the following formula, where N₀ indicates the amplitude value of the periodic load, and I₀ indicates the amplitude value of the electric current caused by the electric charge generated in the piezoelectric thin film W3. $d 33 = \left({I}_{0}/2πf\right) / {N}_{0}$

Here, f indicates the reference frequency.

Further, the piezoelectric constant d33 can be calculated by the following formula, where N_{RMS} indicates the root-mean-square value of the periodic load, and I_{RMS} indicates the root-mean-square value of the electric current caused by the electric charge generated in the piezoelectric thin film W3. $d 33 = \left({I}_{RMS}/2πf\right) / {N}_{RMS}$

Also, the data of the phase difference between the reference frequency signal and the electric current caused by the electric charge generated in the piezoelectric thin film W3, which has been measured by the lock-in amplifier 8, can be inputted to the piezoelectric-constant measurement control means 9 and, from the phase difference, the piezoelectric-constant measurement control means 9 can determine the polarity of the piezoelectric thin film W3.

The piezoelectric-constant measurement control means 9 is realized by a computer (personal computer), in general. For example, as illustrated in Fig. 7, according to a piezoelectric-constant calculating program 91a in a program storage section 91, a CPU 92 outputs, through an output terminal 9a, a signal for controlling the upward and downward movement of the wafer table 2 and further outputs, through an output terminal 9b, a signal for controlling on/off of the output of the reference frequency signal generator 7, through an output section 93. Further, the data of the amplitude value of the periodic load (the data of the value proportional to the amplitude value of the periodic load), which has been measured by the load measuring means 6, and the data of the amplitude value of the electric current caused by the electric charge generated in the piezoelectric thin film W3 (or the data of the value proportional to the amplitude value), which has been measured by the lock-in amplifier 8, are inputted to the CPU 92, through input terminals 9c and 9d, through an input section 94. Further, the CPU 92 calculates the piezoelectric constant d33 according to the aforementioned calculating method, using a working memory section 95 and the like, and outputs it to the outside, through an output terminal 9e, through the output section 93. The data of the piezoelectric constant d33 having been outputted through the output terminal 9e is displayed on a display device (not illustrated), for example.

With the aforementioned piezoelectric constant measuring device 1, in measuring the piezoelectric constant d33 in a state where the upper electrode layer has not been formed, it is possible to eliminate, by the lock-in amplifier 8, noise components added to the electric charge generated in the piezoelectric thin film W3, which makes it possible to accurately measure the electric charge generated in the piezoelectric thin film W3. This enables accurately measuring the piezoelectric constant d33 even by adding a smaller load to the piezoelectric thin film W3.

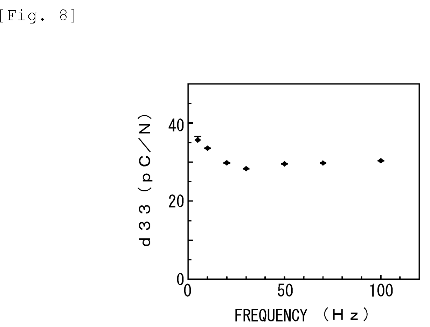

Fig. 8 illustrates the result of measurements (calculations) of a piezoelectric constant d33, which were implemented by applying, through the second electrode 4, a periodic load to a piezoelectric thin film W3 in a wafer WA for experiment (in a state where no upper electrode layer has been formed thereon), and by setting the root-mean-square value of the periodic load to be 0.3 N, while varying the frequency of the reference frequency signal (the reference frequency f). The piezoelectric thin film W3 was a PVDF film. Each measurement was implemented 100 times. In this result, the values of the piezoelectric constants d33 resulted from the respective measurements were converged in the range of ±0.1%. This reveals that it is possible to measure a piezoelectric constant d33 with high accuracy, even by applying a smaller load to a piezoelectric thin film W3, in measuring the piezoelectric constant d33 in a state where no upper electrode layer has been formed thereon. Incidentally, in this experiment, for convenience, an alternating signal outputted from the load detector 61 in synchronization with the reference frequency signal outputted from the reference frequency signal generator 7 is inputted to the second input terminal 8b in the lock-in amplifier 8.

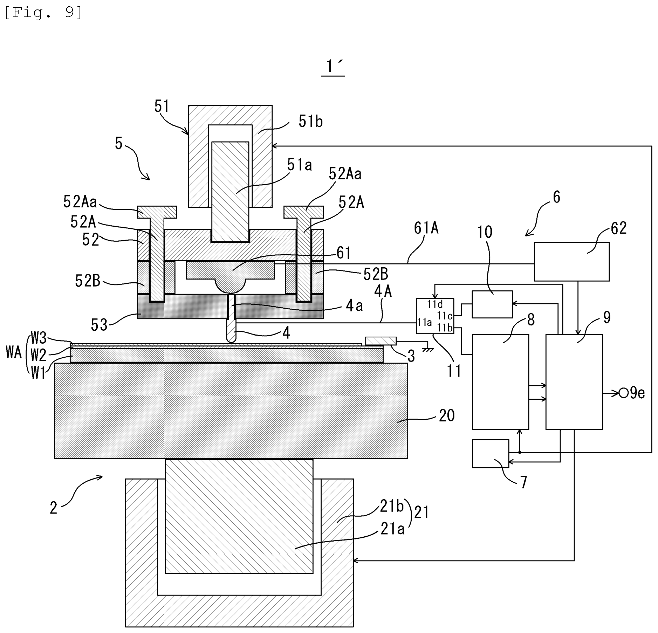

Next, a piezoelectric constant measuring device 1´ will be described. The piezoelectric constant measuring device 1´ includes a pulse generator 10 and a relay 11, in addition to the structure of the piezoelectric constant measuring device 1, as illustrated in Fig. 9.

The pulse generator 10 is capable of generating and outputting pulses with predetermined polarity, height and width. The polarity, the height and the width of pulses are sufficient to control the polarization of a piezoelectric thin film W3, as will be described later. For example, the polarity of pulses can be positive or negative, the height of pulses can be 150 V to 300 V, and the width of pulses can be 10 microseconds to 200 microseconds. The pulse generator 10 can be controlled in on/off by the piezoelectric-constant measurement control means 9.

The relay 11 changes over between passage, therethrough, of the electric current caused by the electric charge generated in the piezoelectric thin film W3, and passage, therethrough, of the pulses outputted from the pulse generator 10. After passing through the relay 11, the pulses are applied to the piezoelectric thin film W3, through the second electrode 4.

Specifically, the relay 11 includes three input/output terminals (a first input/output terminal 11a, a second input/output terminal 11b, and a third input/output terminal 11c), and a single control terminal 11d (see Fig. 9). In a state where a changeover control signal inputted to the control terminal 11d is in one state, there is conduction between the first input/output terminal 11a and the second input/output terminal 11b, while the first input/output terminal 11a and the third input/output terminal 11c are insulated from each other. In a state where the changeover control signal inputted to the control terminal 11d is in the other state, the first input/output terminal 11a and the second input/output terminal 11b are insulated from each other, while there is conduction between the first input/output terminal 11a and the third input/output terminal 11c. The electric lead wire 4A for the second electrode 4 is divided, and the first input/output terminal 11a is connected to the second-electrode-4 side of the divided electric lead wire 4A, while the second input/output terminal 11b is connected to the lock-in-amplifier-8 side of the divided electric lead wire 4A. Further, the third input/output terminal 11c is connected to the output of the pulse generator 10. The relay 11 can be also controlled by the piezoelectric-constant measurement control means 9 (namely, the changeover control signal from the piezoelectric-constant measurement control means 9 can be inputted to the control terminal 11d).

In a state where the changeover control signal for the relay 11 is in one state, the electric current caused by the electric charge generated in the piezoelectric thin film W3 is inputted to the lock-in amplifier 8, which enables the same operations as those of the aforementioned piezoelectric constant measuring device 1. When the changeover control signal for the relay 11 is in the other state, if the pulse generator 10 is in an on state, the pulses outputted from the pulse generator 10 are applied to the piezoelectric thin film W3, through the second electrode 4.

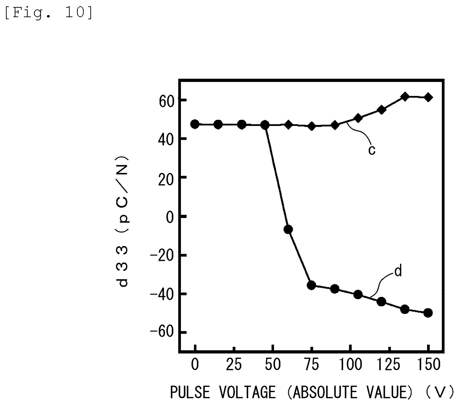

By applying pulses with predetermined polarity, height and width to the piezoelectric thin film W3, the piezoelectric thin film W3 is controlled in polarization. Fig. 10 illustrates the result of measurements (calculations) of a piezoelectric constant d33, which were implemented as follows. That is, pulses were applied, through the second electrode 4, to a piezoelectric thin film W3 in a wafer WA for experiment (in a state where no upper electrode layer has been formed thereon), by setting the pulse polarity to be positive (a curve c) or negative (a curve d), while varying the heights (the pulse voltages) of the pulses. Further, a periodic load was applied thereto after each pulse application. The pulse width was 100 microseconds. The piezoelectric thin film W3 was a PZT film. This result reveals that the polarization of the piezoelectric thin film W3 was appropriately controlled, when the absolute value of the pulse height was equal to or more than about 75 V.

As described above, with the piezoelectric constant measuring device 1´, it is possible to easily control the polarization of the piezoelectric thin film W3, in addition to providing the effects of the piezoelectric constant measuring device 1. Further, in general, the piezoelectric thin film W3 immediately after having been formed is in an unpolarized state, and is in different unclear states at a plurality of positions on the wafer WA. Even if the piezoelectric thin film W3 is so, it is possible to measure the piezoelectric constant d33 with higher accuracy, by controlling the polarization of the piezoelectric thin film W3.

Although the piezoelectric constant measuring device according to the present invention has been described above, the piezoelectric constant measuring device according to the present invention is not limited to those described in the embodiment, and various design changes can be made within the scope of the matters defined in the claims.

For example, in order to measure the piezoelectric constant d33 of a piezoelectric thin film W3 with the piezoelectric constant measuring device 1 (or 1´), it is possible to apply a load to the piezoelectric thin film W3 for measuring the piezoelectric constant d33, by bringing the second electrode 4 into contact with a layer formed above the piezoelectric thin film W3, from thereabove, rather than applying a load to the piezoelectric thin film W3 for measuring the piezoelectric constant d33 by bringing the second electrode 4 into contact with the piezoelectric thin film W3, from thereabove. For example, in a state where an upper electrode layer has been formed and the formed upper electrode layer has been patterned, it is possible to apply a load to the piezoelectric thin film W3 for measuring the piezoelectric constant d33, by bringing the second electrode 4 into contact with the upper electrode layer or with an insulation layer beside (or above) the upper electrode layer, from thereabove. In this case, the inspection is performed as to whether the piezoelectric thin film is appropriate, after the subsequent processing, as compared with inspecting as to whether the piezoelectric thin film is appropriate, in the state where the upper electrode layer has not been formed thereon. However, inspecting as to whether the piezoelectric thin film is appropriate in the state of the wafer WA is advantageous and is particularly advantageous when the piezoelectric thin film W3 is significantly soft.

### Reference Signs List

1, 1´ Piezoelectric constant measuring device
2 Wafer table
20 Wafer-table main body
21 First linear motor
21a Linear movement portion of the first linear motor
21b Supporting portion of the first linear motor
3 First electrode
4 Second electrode
4a Securing portion of the second electrode
4h Base portion (holder portion) of the second electrode
4l Base portion (lower ball-shaped portion) of the second electrode
4A Electric lead wire for the second electrode
5 Second-electrode load means
51 Second linear motor
51a Linear movement portion of the second linear motor
51b Supporting portion of the second linear motor
52 Load-detector attachment plate
52A Load-detector attachment-plate sliding rod
52Aa Head portion of the load-detector attachment-plate sliding rod
52B Load-detector holding spring
53 Second-electrode attachment plate
6 Load measuring means
61 Load detector
61A Electric lead wire for the load detector
62 Load-measurement processor
7 Reference frequency signal generator
8 Lock-in amplifier
8a First input terminal of the lock-in amplifier
8b Second input terminal of the lock-in amplifier
8c First output terminal of the lock-in amplifier
8d Second output terminal of the lock-in amplifier
81 First mixer in the lock-in amplifier
82 First low-pass filter in the lock-in amplifier
83 Phase shifter in the lock-in amplifier
84 Second mixer in the lock-in amplifier
85 Second low-pass filter in the lock-in amplifier
86 Polar coordinate transformation unit in the lock-in amplifier
9 Piezoelectric-constant measurement control means
9a, 9b, 9eOutput terminal of the piezoelectric-constant measurement control means
9c, 9d Input terminal of the piezoelectric-constant measurement control means
91 Program storage section in the piezoelectric-constant measurement control means
91a Piezoelectric-constant calculating program in the piezoelectric-constant measurement control means
92 CPU in the piezoelectric-constant measurement control means
93 Output section in the piezoelectric-constant measurement control means
94 Input section in the piezoelectric-constant measurement control means
95 Working memory section in the piezoelectric-constant measurement control means
10 Pulse generator
11 Relay
11a First input/output terminal of the relay
11b Second input/output terminal of the relay
11c Third input/output terminal of the relay
11d Control terminal of the relay
WA Wafer
W1 Substrate
W2 Lower electrode layer
W3 Piezoelectric thin film

## Claims

1. A piezoelectric constant measuring device for measuring a piezoelectric constant d33 of a piezoelectric thin film formed on a lower electrode layer on a substrate in a wafer, the piezoelectric constant measuring device comprising:
a wafer table adapted to support the substrate;
a first electrode which is grounded and can come in contact with a predetermined portion of the wafer;
a second electrode;
a second-electrode load means which is controlled by a reference frequency signal and can apply a periodic load with a frequency, which is equal to a frequency of the reference frequency signal, to the piezoelectric thin film through the second electrode;
a load measuring means adapted to convert the periodic load into an alternating signal and output an amplitude value of the periodic load or a value proportional thereto;
a reference frequency signal generator adapted to generate and output the reference frequency signal;
a lock-in amplifier to which an electric current caused by an electric charge generated in the piezoelectric thin film due to the periodic load applied thereto is inputted, as a to-be-measured signal, through the second electrode, and to which the reference frequency signal or the alternating signal is inputted as a reference signal, and moreover which outputs an amplitude value of the to-be-measured signal or a value proportional thereto; and
a piezoelectric-constant measurement control means adapted to calculate the piezoelectric constant d33 from the amplitude value of the to-be-measured signal or the value proportional thereto and from the amplitude value of the periodic load or the value proportional thereto.

2. The piezoelectric constant measuring device according to claim 1, further comprising:
a pulse generator capable of generating a pulse with predetermined polarity, height and width; and
a relay adapted to change over between passage of the electric current caused by the electric charge generated in the piezoelectric thin film, and passage of the pulse,
wherein the pulse is applied to the piezoelectric thin film through the second electrode, after passing through the relay.

3. The piezoelectric constant measuring device according to claim 1 or 2, wherein
the second electrode includes a base portion formed from a synthetic resin, with metal being adhered to a surface of at least a lower portion of the base portion.
